# EUROPEAN PATENT APPLICATION

(11) **EP 4 535 930 A1**
(43) Date of publication of application: **09.04.2025**
(21) Application number: 24204684.5
(22) Date of filing: 04.10.2024
(51) Int. Cl.: H05K 1/02, H02M 7/00, H02M 1/44, H05K 7/20

(54) **PRINTED CIRCUIT BOARD AND AN INDUCTION COOKTOP INCLUDING THE PRINTED CIRCUIT BOARD**

(30) Priority: 06.10.2023 US 202318377527
(71) Applicant: Whirlpool Corporation, Benton Harbor, MI 49022 (US)
(72) Inventor: GALLIVANONI, Andrea, c/o Whirlpool Corporation, Benton Harbor, 49022 (US); BARBATI, Mario, c/o Whirlpool Corporation, Benton Harbor, 49022 (US); BALDO, Salvatore, c/o Whirlpool Corporation , Benton Harbor, 49022 (US)
(74) Representative: Eisenführ Speiser

(57) **Abstract**

A printed circuit board (16) including (a) a heat sink (52) projecting from a first primary surface (42) and defining a first section (48) and a second section (50) of the first primary surface (42), (b) one or more rectifier components (60), (c) a smoothing component (72) disposed at the first section (48) in electrical communication with the one or more rectifier components (60), (d) inverter components (78) in electrical communication with the one or more rectifier components (60) and the smoothing component (72), the inverter components (78) including (i) at least one capacitor and at least one connector (84) for an induction coil (14) both disposed at the second section (50) and (ii) a controllable solid-state switching device (88) functionally operable with the at least one capacitor and the at least one connector (84) disposed at a second primary surface (44) of the printed circuit board (16) or second section (50) of the first primary surface (42).

## Description

### FIELD OF DISCLOSURE

This disclosure pertains to a printed circuit board design that includes inverter components, such as that used for an induction cooktop, and more particularly to reducing electromagnetic interference from the inverter components.

### BACKGROUND

A power converter is an electronic device that converts electrical power from one form to another, such as from direct current power to alternating current power, or vice-versa. In the context of induction cooktops, several power converters are utilized. The first power converter, referred to as a rectifier, converts the AC voltage from the AC mains into a DC voltage suitable for the induction cooktop. The second power converter, referred to as a DC-to-AC inverter, converts the DC voltage into an AC voltage with a frequency suitable to power a resonant load that includes a cookware on the cooktop. Similar DC-to-AC inverters are utilized in renewable energy systems, electric vehicle charging, and electric railcars (e.g., electric multiple unit), among other things.

However, there is a problem in that DC-to-AC inverters for induction cooktops utilize printed circuit boards that are suboptimally designed with the capacitors that are part of the resonant load circuit (encountering high frequency) disposed on the printed circuit board too closely to the capacitors that are coupled to the DC input (encountering low frequency). The low frequency part of the circuit (where the capacitors are connected to the DC-bus) too close to the high frequency part of the circuit (where the capacitors are connected to the resonant load circuit) can lead to interference from the high frequency side to the low frequency one, causing EMI in the AC mains line side that can lower electromagnetic compatibility.

### SUMMARY

The present disclosure addresses that problem with a printed circuit board that places a heat sink physically between the capacitor(s) of the resonant circuit and the capacitor(s) connected to the DC-bus. In addition, rectifier components can be disposed with the capacitor(s) connected to the DC-bus, or on the other side of the printed circuit board to the same side of the heat sink as the capacitor(s) connected to the DC-bus. Further, controllable solid-state switching devices to drive the resonant circuit are placed either on the other side of the printed circuit board or on the side of the heat sink with the capacitor(s) of the resonant circuit. The printed circuit board thus physically separates high frequency components associated with the resonant circuit from low frequency components associated with rectified DC voltage.

In one aspect, a printed circuit board comprises: (a) a first edge; (b) a second edge facing an opposite direction as the first edge; (c) a first primary surface comprising a first section and a second section, the first section being disposed closer to the first edge than the second section, and the second section being disposed closer to the second edge than the first section; (d) a second primary surface facing an opposite direction as the first primary surface; (e) a heat sink projecting from the first primary surface, laterally between the first edge and the second edge, and laterally between the first section and the second section of the first primary surface; (f) one or more rectifier components configured to convert alternating current (AC) voltage to rectified direct current (DC) voltage; (g) a smoothing component projecting from the first primary surface side at the first section, the smoothing component (i) in electrical communication with the one or more rectifier components and (ii) configured to smooth out the rectified DC voltage and output a smoothed DC voltage; and (h) inverter components in electrical communication with the one or more rectifier components and the smoothing component, the inverter components comprising (i) at least one capacitor and at least one connector for an induction coil both projecting from the first primary surface of the printed circuit board at the second section and (ii) a controllable solid-state switching device functionally operable with the at least one capacitor and the at least one connector.

In another aspect, an induction cooktop comprises: (1) a printed circuit board comprising: (a) a first edge; (b) a second edge facing an opposite direction as the first edge; (c) a first primary surface comprising a first section and a second section, the first section being disposed closer to the first edge than the second section, and the second section being disposed closer to the second edge than the first section; (d) a second primary surface facing an opposite direction as the first primary surface; (e) a heat sink projecting from the first primary surface, laterally between the first edge and the second edge, and laterally between the first section and the second section of the first primary surface; (f) one or more rectifier components configured to convert alternating current (AC) voltage to rectified direct current (DC) voltage; (g) a smoothing component projecting from the first primary surface side at the first section, the smoothing component (i) in electrical communication with the one or more rectifier components and (ii) configured to smooth out the rectified DC voltage and output a smoothed DC voltage; and (h) inverter components in electrical communication with the one or more rectifier components and the smoothing component, the inverter components comprising (i) at least one capacitor and at least one connector for an induction coil, both projecting from the first primary surface of the printed circuit board at the second section and (ii) a controllable solid-state switching device functionally operable with the at least one capacitor and the at least one connector; (2) an induction coil connected to the at least one connector, the induction coil paired with the at least one capacitor to form a resonant circuit; (3) a controller in electrical communication with the controllable solid-state switching device, the controller configured to drive the controllable solid-state switching device to provide an excitation signal to the resonant circuit; and (4) a substrate providing a cooking surface for cookware, wherein the one or more induction coils, the printed circuit board, and the controller are disposed below the substrate.

### BRIEF DESCRIPTION OF THE DRAWINGS

In the Drawings:

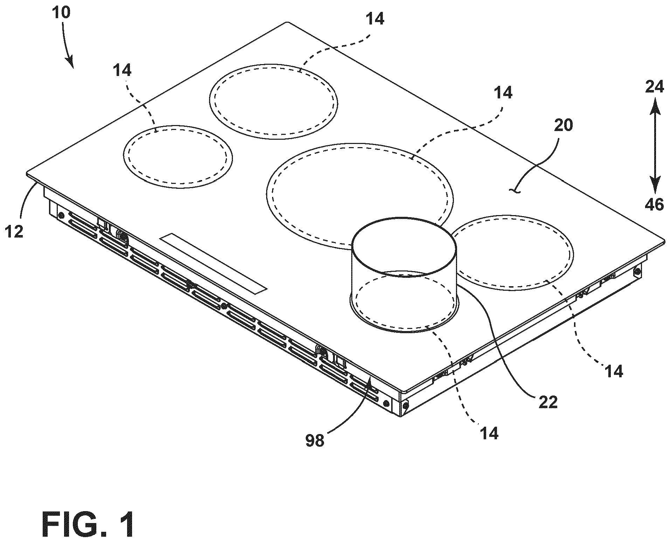

FIG. 1 is a perspective view of an induction cooktop of the present disclosure, illustrating the induction coil disposed beneath a substrate that provides a cooking surface that supports a cooking vessel;

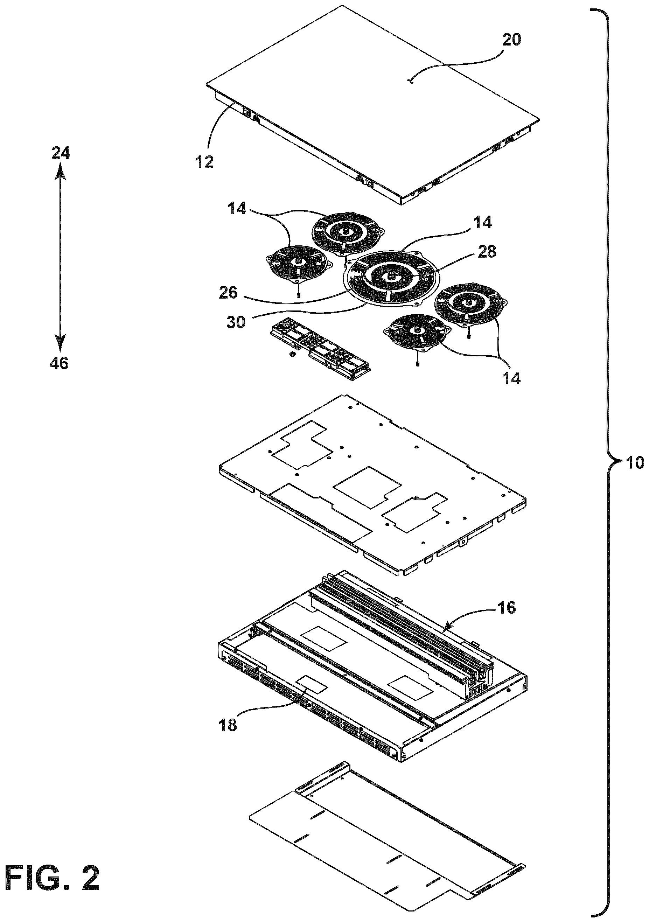

FIG. 2 is a perspective exploded view of the induction cooktop of FIG. 1, illustrating a controller and a printed circuit board disposed under the substrate;

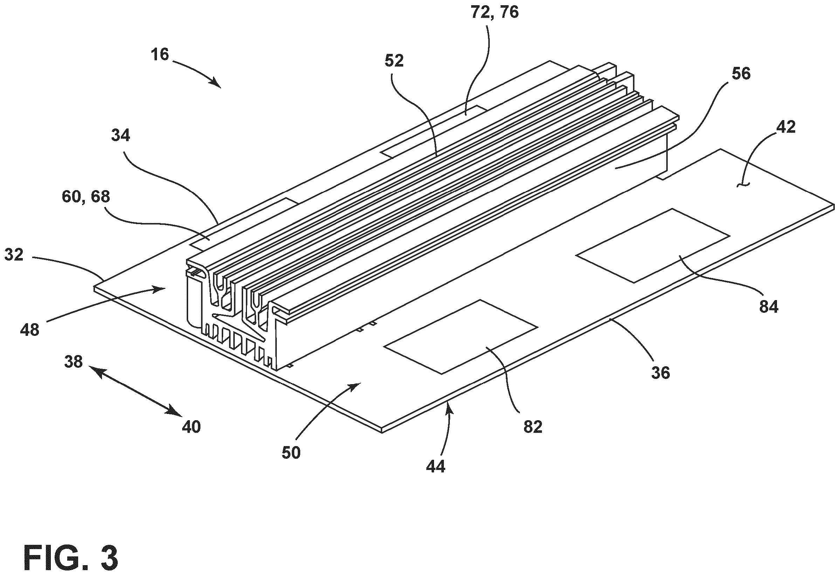

FIG. 3 is a top perspective view of the printed circuit board, illustrating a heat sink disposed on a first primary surface of a core of the printed circuit board and dividing the first primary surface into (i) a first section where rectifier components and a smoothing component are disposed and (ii) a second section where at least one capacitor and at least one connector for the induction coil are disposed;

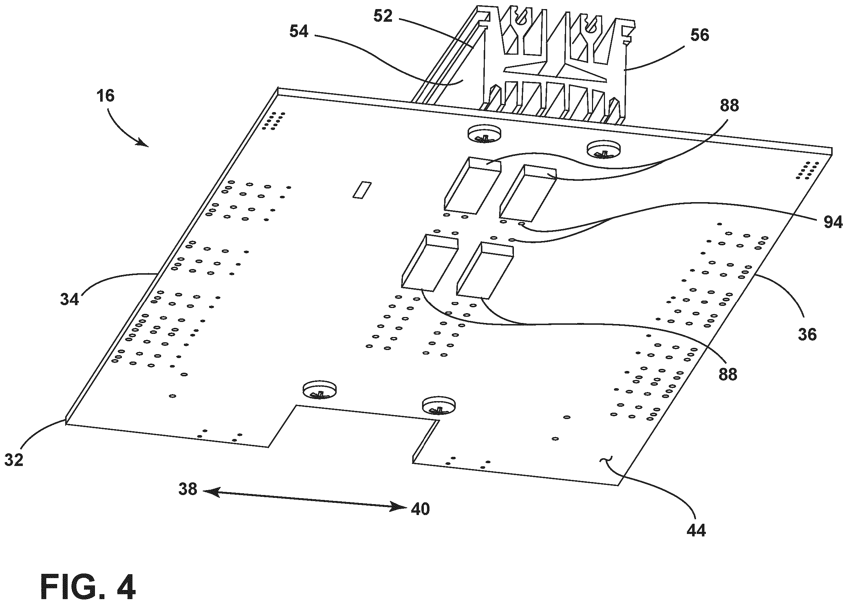

FIG. 4 is a bottom perspective view of the printed circuit board, illustrating a controllable power semiconductor device disposed at a second primary surface of the printed circuit board but in thermal communication with the heat sink by way of through-holes through the core of the printed circuit board;

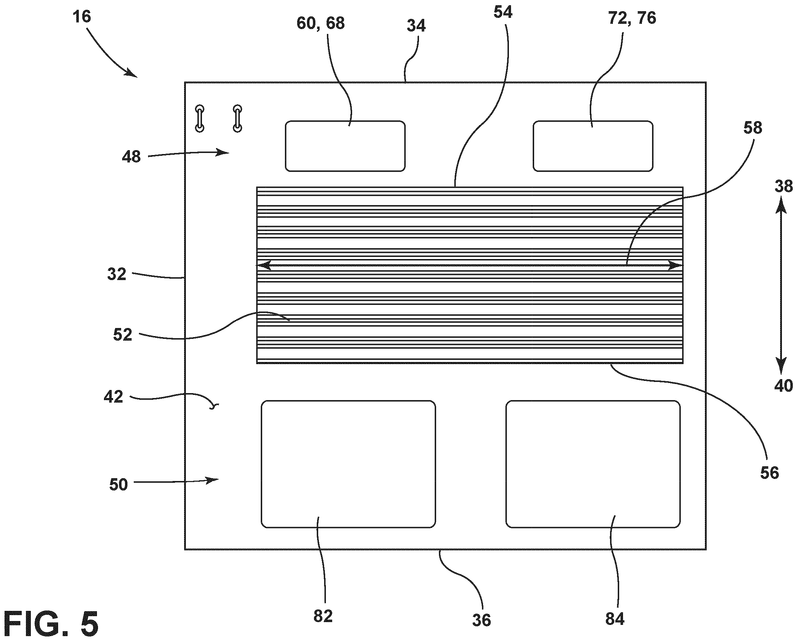

FIG. 5 is top plan view of the printed circuit board, illustrating again the heat sink dividing the top primary surface of the core of the printed circuit board into different sections where different components of the power supply for the induction coil are disposed to reduce electromagnetic interference;

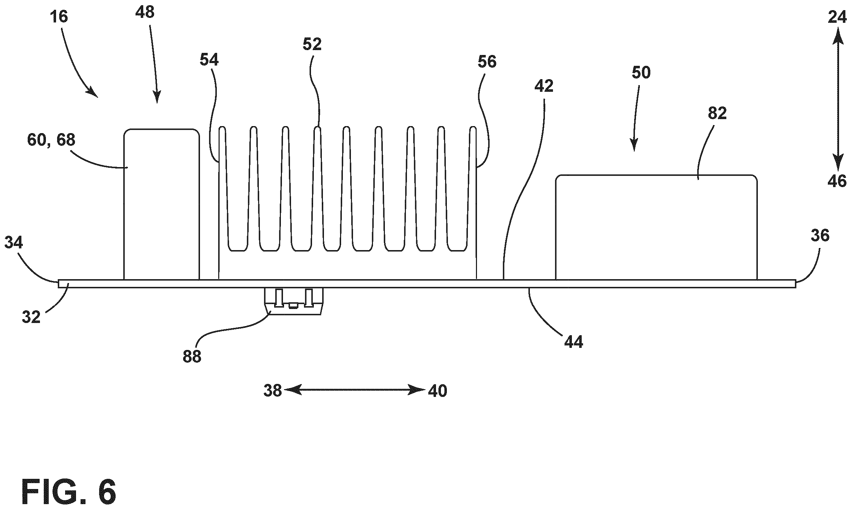

FIG. 6 is an elevational view of the printed circuit board, illustrating the controllable solid-state switching device disposed on the opposite side of the core as the heat sink, again to reduce electromagnetic interference;

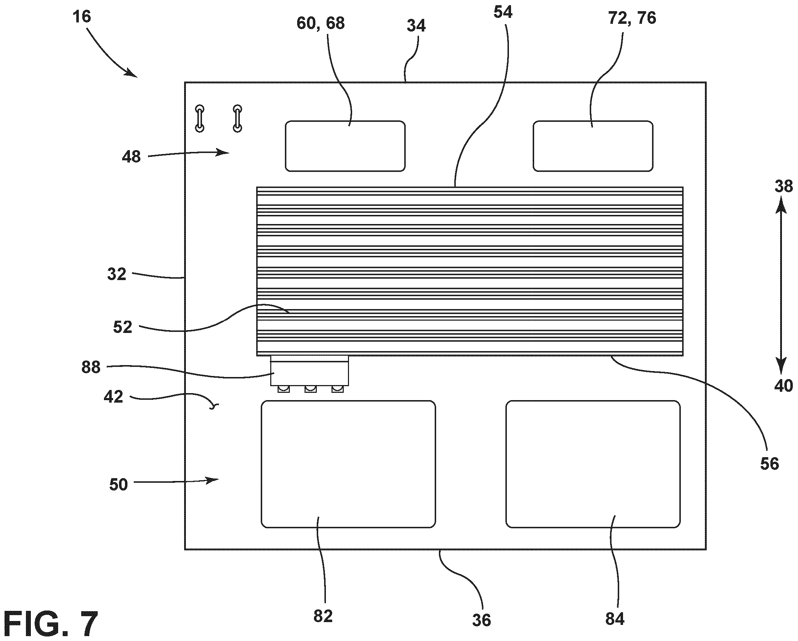

FIG. 7 is a top plan view of another embodiment of a printed circuit board for use with the induction cooktop of FIG. 1, illustrating the controllable solid-state switching device this time disposed at the first primary surface of the core but attached to the heat sink to face in the direction of the second section where the at least one capacitor and the at least one connector for the induction coil are located, thus separating those inverter components from the rectifier components and the smoothing component to reduce electromagnetic interference;

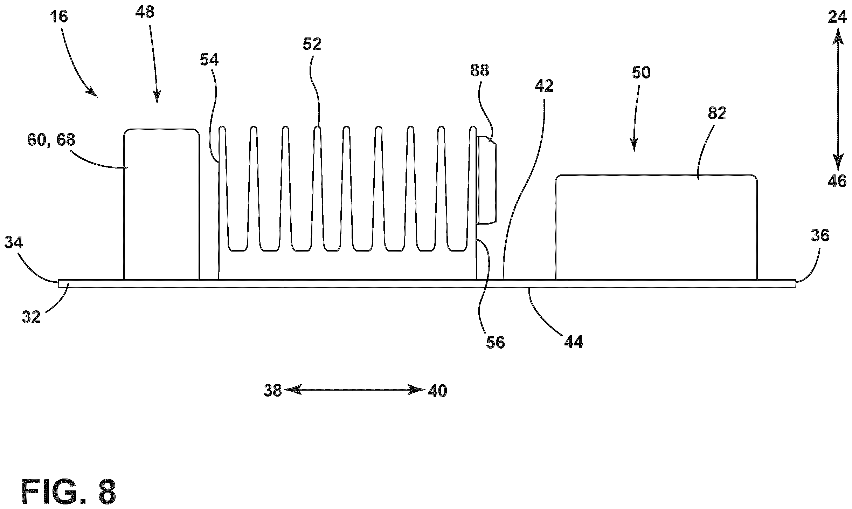

FIG. 8 is an elevational view of the printed circuit board of FIG. 7;

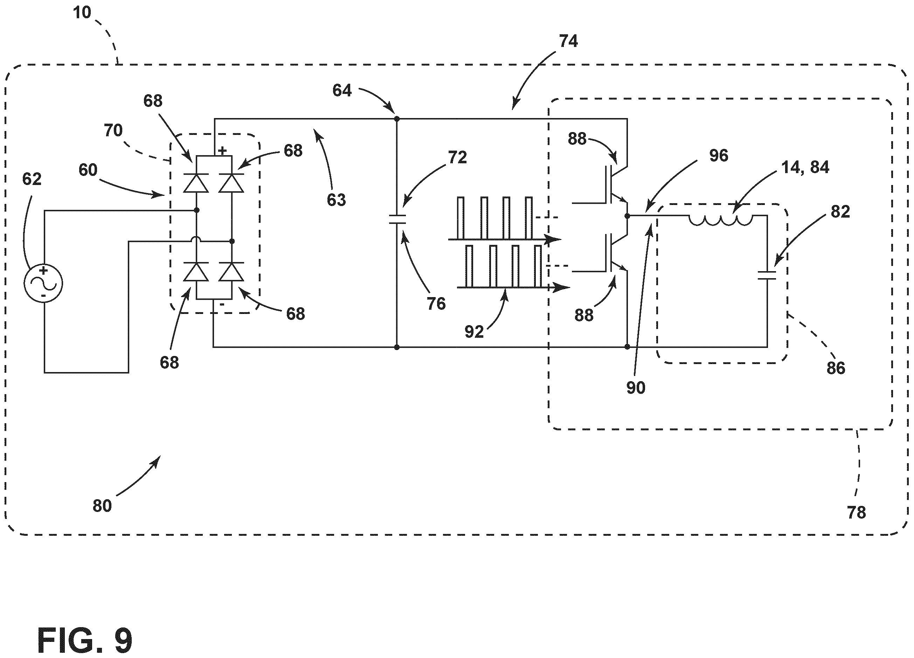

FIG. 9 is a schematic illustration of an electrical circuit of the induction cooktop, the components of which are disposed on the printed circuit board of the present disclosure;

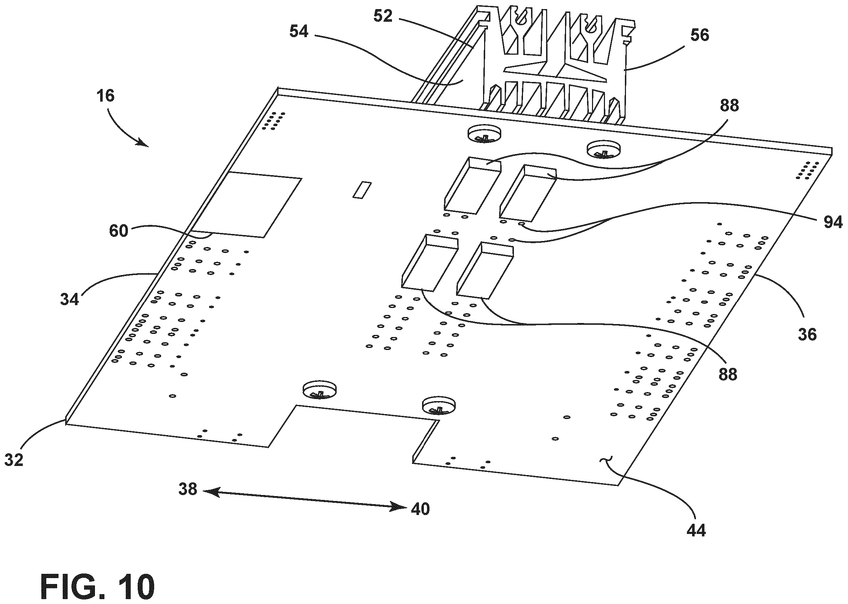

FIG. 10 is similar to FIG. 4 but further illustrating the rectifier components disposed at the second primary surface of the printed circuit board and closer to a first edge than a second edge of the core (e.g., under the first section of the first primary surface);

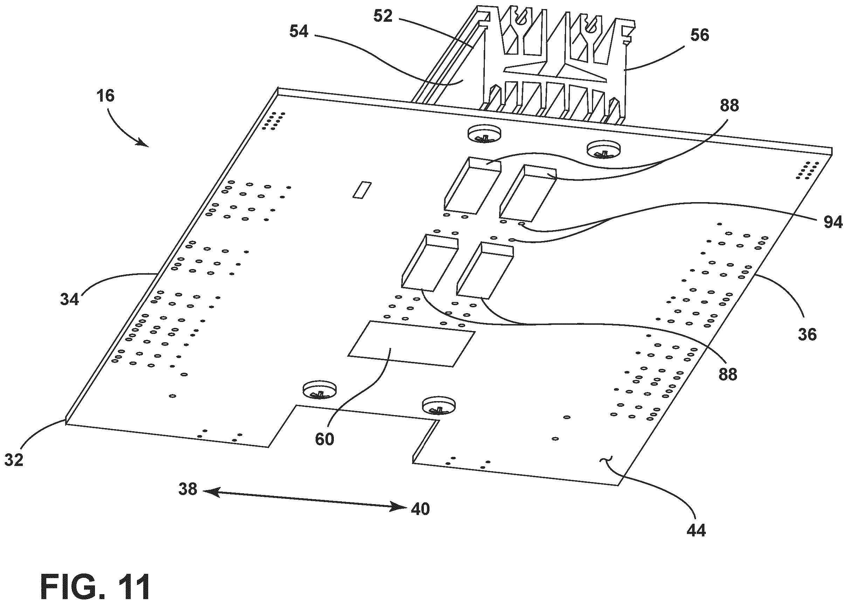

FIG. 11 is also similar to FIG. 4 but further illustrating the rectifier components disposed at the secondary primary surface of the printed circuit board directly opposing the heat sink (e.g., under the heat sink) and connected thereto by way of through-holes through the core of the printed circuit board;

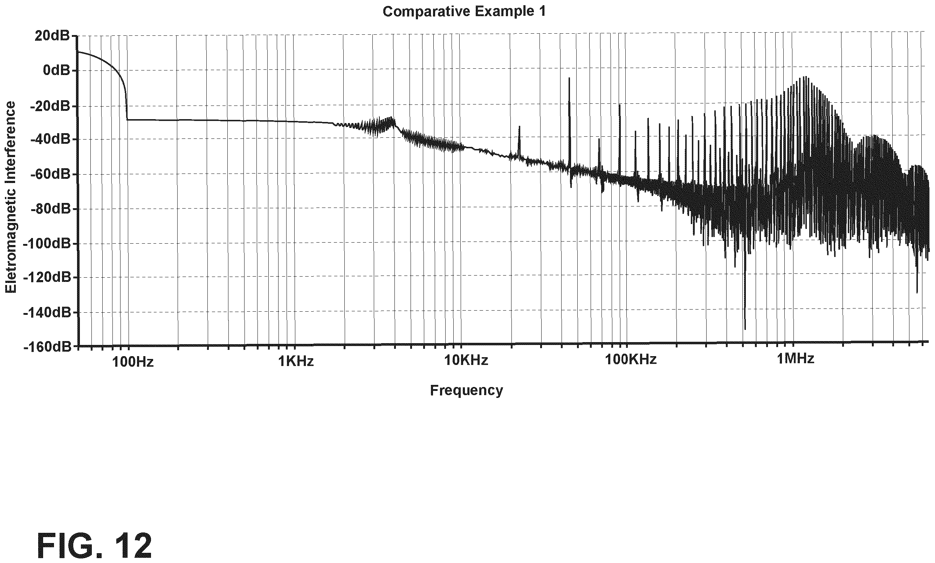

FIG. 12, pertaining to a Comparative Example 1, is a graph plotting magnitude of electromagnetic interference (in dB) as a function of frequency of electromagnetic radiation (in kHz) emitted for an induction cooktop that did not include the printed circuit board of the present disclosure, at a fixed power and fixed switching frequency; and

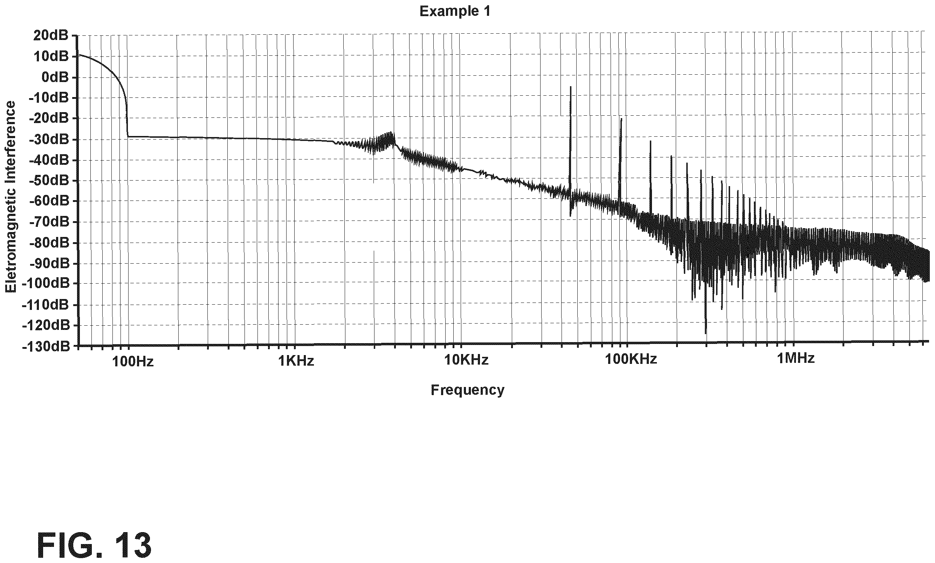

FIG. 13, pertaining to an Example 1, is a graph plotting magnitude of electromagnetic interference (in dB) as a function of frequency of electromagnetic radiation (in kHz) emitted for an induction cooktop that did include the printed circuit board of the present disclosure, showing that the printed circuit board of the present disclosure reduces electromagnetic interference.

The drawings are not necessarily to scale and are exemplary of various embodiments.

### DETAILED DESCRIPTION

Referring to FIGS. 1-2, an induction cooktop 10 includes a substrate 12, an induction coil 14, a printed circuit board 16, and a controller 18. The substrate 12 provides a cooking surface 20 for cookware 22. The cooking surface 20 is generally horizontal and faces an upward direction 24. The substrate 12 can be any material that suitably tolerates cooking temperatures and does not interfere with magnetic fields that the induction coil 14 produces. For example, the substrate 12 can have a glass-ceramic composition or a glass composition. However, other materials such as stone, ceramic, wood, stainless steel, and composites of the aforementioned are envisioned. The substrate 12 may be transparent, partially transparent, or opaque. The cookware 22 includes ferromagnetic material that can generate eddy currents when exposed to the alternating magnetic fields that the induction coil 14 produces. The controller 18 can include a microprocessor and memory. The induction cooktop 10 can be a standalone unit or a component of a larger assembly, such as a component of a free-standing range.

The induction coil 14 is disposed below the substrate 12 and thus below the cooking surface 20. The induction coil 14 includes wire 26. The wire 26 is typically made of a metal such as copper. The wire 26 is wound around a center point 28, typically in a flat circular shape, although other shapes are commonly used. A coil support 30, which may be made of plastic, maintains the shape of the wound wire 26. The induction coil 14 generates a magnetic field when the wire 26 carries an electrical current. The induction coil 14 is positioned relative to the substrate 12 so that the magnetic field that the induction coil 14 generates transmits through the substrate 12 to interact with the cookware 22.

Referring additionally to FIGS. 3-9, the printed circuit board 16, like the induction coil 14, is disposed below the substrate 12. The printed circuit board 16 includes a core 32 presenting a first edge 34 and a second edge 36. The first edge 34 and the second edge 36 face in opposite directions 38, 40. The core 32 of the printed circuit board 16 further includes a first primary surface 42 and a second primary surface 44. The first primary surface 42 and the second primary surface 44 face in opposite directions. For example, when assembled into the induction cooktop 10 horizontally, the first primary surface 42 faces in the upward direction 24, while the second primary surface 44 faces in a downward direction 46. Alternatively, the second primary surface 44 might face in the upward direction 24, while the first primary surface 42 faces in the downward direction 46. Or the printed circuit board 16 could be oriented vertically. Other orientations are possible.

The first primary surface 42 includes a first section 48, a second section 50, and a heat sink 52. The first section 48 is disposed closer to the first edge 34 than the second section 50. Similarly, the second section 50 is disposed closer to the second edge 36 than the first section 48.

The heat sink 52 projects from the first primary surface 42. For example, when the first primary surface 42 faces the upward direction 24, the heat sink 52 projects in the upward direction 24 from the first primary surface 42. The heat sink 52 is disposed laterally between the first edge 34 and the second edge 36. Further, the heat sink 52 is disposed laterally between the first section 48 and the second section 50 of the first primary surface 42. In that manner, the heat sink 52 helps define and bound the first section 48 and the second section 50 and separates the first section 48 from the second section 50. The first section 48 is disposed to one side 54 of the heat sink 52, while the second section 50 is disposed to another side 56 of the heat sink 52. The heat sink 52 facilitates the dissipation of heat from other components (to be discussed) on the printed circuit board 16. The dissipation of heat can be useful to prevent overheating of those components, which might cause the induction cooktop 10 to operate suboptimally. The heat sink 52 can be made of (or include) a material with a relatively high thermal conductivity, such as aluminum or copper. Other materials are envisioned. In embodiments, such as that illustrated, the heat sink 52 has a longest dimension 58 that can be parallel to the first edge 34 and the second edge 36 of the printed circuit board 16.

Referring additionally to FIGS. 9-11, the printed circuit board 16 further includes one or more rectifier components 60. The rectifier components 60 are configured to convert alternating current (AC) voltage 62 to rectified direct current (DC) voltage 63. In embodiments, the AC voltage 62 that the rectifier components 60 converts is from the mains of the house or other building within which the induction cooktop 10 is located. The rectifier components 60 output the rectified DC voltage 63 to a DC-bus 64. The one or more rectifier components 60 can include, as in the illustrated embodiment, diodes 68 (e.g., four diodes 68) arranged as a bridge rectifier circuit 70. The bridge rectifier circuit 70 can be a Surface Mount Device (SMD) bridge rectifier.

In embodiments, the rectifier components 60 project from the first primary surface 42 of the printed circuit board 16 at the first section 48 (see, e.g., FIG. 3). In embodiments, the rectifier components 60 project exclusively from the first primary surface 42 of the printed circuit board 16 at the first section 48. In some instances, all the rectifier components 60 that participate in the conversion of the AC voltage 62 to the rectified DC voltage 63 are disposed to the one side 54 of the heat sink 52 at the first section 48. In those instances, there are no rectifier components 60 that participate in the conversion of the AC voltage 62 to the rectified DC voltage 63 that project from the first primary surface 42 at the second section 50, that is, to the other side 56 of the heat sink 52. In embodiments, there are no rectifier components 60 that participate in the conversion of the AC voltage 62 to the rectified DC voltage 63 that project from the second primary surface 44 of the printed circuit board 16.

However, in other embodiments, the rectifier components 60 that participate in the conversion of the AC voltage 62 to the rectified DC voltage 63 project from the second primary surface 44 of the printed circuit board 16. In some instances, the rectifier components 60 project from the second primary surface 44 of the printed circuit board 16 under the first section 48 of the first primary surface 42 - for example closer to the first edge 34 than the second edge 36 (see, e.g., FIG. 10). In other instances, the rectifier components 60 project from the second primary surface 44 of the printed circuit board 16, directly opposite the heat sink 52 and in thermal communication therewith by way of through-holes 94 or a cutout through the core 32 of the printed circuit board 16.

The printed circuit board 16 further includes a smoothing component 72. The smoothing component 72 is in electrical communication with the rectifier components 60 through the DC-bus 64 and experiences the rectified DC voltage 63. The smoothing component 72 is configured to smooth out the rectified DC voltage 63 and output a smoothed DC voltage 74. In embodiments, the smoothing component 72 is or includes a capacitor. In embodiments, the smoothing component 72 is or includes a DC-bus capacitor 76. The capacitor (e.g., the DC-bus capacitor 76) may be the only smoothing component 72.

The smoothing component 72 projects from the first primary surface 42 of the printed circuit board 16 at the first section 48. Stated another way, all the smoothing components 72 that smooth the rectified DC voltage 63 are disposed to the one side 54 of the heat sink 52 at the first section 48. There are no smoothing components 72 that smooth the rectified DC voltage 63 that project from the first primary surface 42 at the second section 50, that is, to the other side 56 of the heat sink 52. In embodiments, there are no smoothing components 72 that smooth the rectified DC voltage 63 that project from the second primary surface 44 of the printed circuit board 16.

The printed circuit board 16 further includes inverter components 78. The inverter components 78 are in electrical communication with the one or more rectifier components 60 and the smoothing component 72. For example, the inverter components 78, the one or more rectifier components 60, and the smoothing component 72 are part of an electrical circuit 80. The inverter components 78 include at least one capacitor 82 and at least one connector 84 for the induction coil 14. In the embodiment of FIG. 9, the at least one capacitor 82 is illustrated in series with the at least one connector 84 for the induction coil 14. In other embodiments, the at least one capacitor 82 is in parallel with the at least one connector 84. In any event, the at least one connector 84 is paired with the at least one capacitor 82 to form a resonant circuit component 86 of the electrical circuit 80. When the induction coil 14 is connected to the at least one connector 84, the at least one capacitor 82 is configured to achieve continuous resonance with the induction coil 14, with energy exchanging between the two components.

The at least one capacitor 82 and the at least one connector 84 project from the first primary surface 42 of the printed circuit board 16 at the second section 50 thereof. The at least one capacitor 82 and the at least one connector 84 are thus on the other side 56 of the heat sink 52 as the smoothing component 72, which is on the one side 54 of the heat sink 52. The heat sink 52 spatially separates the at least one capacitor 82 and the at least one connector 84 from the smoothing component 72. There are no capacitors 82 or connectors 84 of the resonant circuit component 86 projecting from the first primary surface 42 of the printed circuit board 16 at the first section 48. In embodiments, there are no capacitors 82 or connectors 84 of the resonant circuit component 86 projecting from the second primary surface 44 of the printed circuit board 16.

The inverter components 78 further include a controllable solid-state switching device 88. The controllable solid-state switching device 88 is functionally operable with the at least one capacitor 82 and the at least one connector 84. For example, the controllable solid switching device 88 can be in electrical communication with the at least one capacitor 82 and the at least one connector 84 (e.g., part of the electrical circuit 80). The controllable solid-state switching device 88 is configured to receive and convert the smoothed DC voltage 74 from the smoothing component 72 into a high-frequency AC voltage 90 that is delivered to the at least one connector 84 (and thus the induction coil 14 attached to the at least one connector 84) according to a switching control 92 from the controller 18. In embodiments, the controllable solid-state switching device 88 includes one or more of a power metal-oxide semiconductor field-effect transistor (MOSFET), an insulated-gate bipolar transistor (IGBT), a thyristor, a silicon-controlled rectifier (SCR), a silicon carbide (SiC) transistor, and a gallium nitride (GaN) transistor. Other devices are contemplated, and that list is not meant to be exhaustive. The controllable solid-state switching device can include any controllable power semiconductor device.

In embodiments, the controllable solid-state switching device 88 projects from the second primary surface 44 of the printed circuit board 16, directly opposing the heat sink 52 with the core 32 disposed between the heat sink 52 and the controllable solid-state switching device 88. In such embodiments, the controllable solid-state switching device 88 is in thermal communication with the heat sink 52 by way of the through-holes 94 or cutouts through the printed circuit board 16. Further, in these embodiments, there can be instances where no controllable solid-state switching devices 88 project from the first primary surface 42 of the printed circuit board 16. These embodiments may be combined with the embodiments where the rectifier components 60 also project from the second primary surface 44 of the printed circuit board 16, directly opposite the heat sink 52 and in thermal communication therewith by way of the through-holes 94 through the core 32 of the printed circuit board 16 or a cutout through the PCB.

In other embodiments, the controllable solid-state switching device 88 is attached to the other side 56 of the heat sink 52 facing the second section 50 of the printed circuit board 16. In such embodiments, there are no controllable solid-state switching devices 88 attached to the one side 54 of the heat sink 52 to face the first section 48 of the printed circuit board 16.

In still other embodiments, there are multiple controllable solid-state switching devices 88, and at least one controllable solid-state switching device 88 is attached to the heat sink 52 to face toward the second section 50 of the printed circuit board 16, while at least one controllable solid-state switching device 88 projects from the second primary surface 44 of the printed circuit board 16 under the heat sink 52. The latter is in thermal communication with the heat sink 52 by way of through-holes 94 through the printed circuit board 16.

When installed with the induction cooktop 10, the induction coil 14 is connected to the at least one connector 84. The induction coil 14, when connected to the at least one connector 84, is paired with the at least one capacitor 82 as part of the resonant circuit component 86 within the electrical circuit 80. It should be understood that, in FIG. 9, the induction coil 14 is not part of the printed circuit board 16, but the at least one connector 84 is part of the printed circuit board 16. As mentioned, the controller 18 is in electrical communication with the controllable solid-state switching device 88. The controller 18 is configured to drive the controllable solid-state switching device 88 (e.g., with the switching control 92) to provide an excitation signal 96 to the resonant circuit component 86. The controller 18 can be positioned on the printed circuit board 16, and can be a microcontroller, such as near the second edge 36. The induction coil 14 is positioned, in response to the excitation signal 96, to generate a rapidly changing magnetic field that, in turn, induces eddy currents within the cookware 22 placed upon the cooking surface 20. For example, the induction coil 14 can be horizontally oriented and in contact with a bottom surface 98 of the substrate 12. The bottom surface 98 faces in the downward direction 46 while the cooking surface 20 faces in the upward direction 24. The controller 18 is disposed below the substrate 12 with the induction coil 14 and the printed circuit board 16. The controller 18 can be disposed below the printed circuit board 16.

The printed circuit board 16 of the present disclosure addresses the problems set forth in the background in a variety of ways. The controllable solid-state switching device 88 being in thermal communication with the heat sink 52 provides adequate cooling. Further, the heat sink 52 physically separating the smoothing component 72 (e.g., the DC-bus capacitor 76), and in some instances the rectifier components 60 (e.g., the diodes 68 arranged as the bridge rectifier circuit 70), from the at least one capacitor 82 and the at least one connector 84 for the induction coil 14 reduces electromagnetic interference. In short, the components of the electrical circuit 80 addressing power delivered to the induction coil 14 are split into two parts - the DC-bus capacitor 76 at the first section 48 (and in some instances the bridge rectifier circuit 70), and the at least one capacitor 82 and the at least one connector 84 at the second section 50, with the heat sink 52 separating the first section 48 from the second section 50. The controllable solid-state switching device 88 is either disposed at the second primary surface 44 of the printed circuit board 16 under the heat sink 52 or attached to the heat sink 52 to face toward the second section 50. Electromagnetic emissions from the at least one capacitor 82, the at least one connector 84, and the controllable solid-state switching device 88 thus do not substantially return back to the mains.

Although the printed circuit board 16 has been described in the context of the induction cooktop 10 application, the printed circuit board 16 of the present disclosure is useful for other applications, such a multiple-unit train.

Further, although the present disclosure has discussed various components in the singular (e.g., the controllable solid-state switching device 88, the induction coil 14, and so on), it should be understood that the induction cooktop 10 can include multiple of those components (e.g., multiple induction coils 14, multiple printed circuit boards 16, and so on). Further, the printed circuit board 16 can include multiple sets of rectifier components 60, multiple smoothing components 72, and so on, arranged in the same manner as the single versions herein described. For example, multiple smoothing components 72 in electrical communication with the multiple rectifier components 60 and configured to smooth out the rectified DC voltage 63 and output smoothed DC voltage 74 can project from the first primary surface 42 exclusively at the first section 48. In addition, multiple capacitors 82 and multiple connectors 84 can exclusively project from the first primary surface 42 at the second section 50. Further, multiple controllable solid-state switching devices 88 configured to convert the smoothed DC voltage 74 into high-frequency AC voltage 90 can all be in thermal communication with the heat sink 52 and either (i) exclusively project from the second primary surface 44 of printed circuit board 16, (ii) exclusively be attached to the heat sink 52 at the second section 50 of the printed circuit board 16 at or above the first primary surface 42, or (iii) a combination of (i) and (ii). Multiple rectifier components 60 configured to convert AC voltage 62 to rectified DC voltage 63 can project from the first primary surface 42 exclusively at the first section 48, or project exclusively from the second primary surface 44 under the heat sink 52 or under the first section 48.

### Examples

*Comparative Example 1* - For Comparative Example 1, a printed circuit board not of the present disclosure was prepared with diodes of a bridge rectifier circuit, a DC-bus capacitor, a capacitor, two connectors connected to an induction coil, and a controllable solid-state switching device not separated from each other in any manner by a heat sink. Magnitude of electromagnetic interference (in dB) was then measured as a function of frequency (in kHz) of the electromagnetic emissions at a fixed power and fixed switching frequency. The measurements were then plotted on a graph, which is reproduced at FIG. 12.

*Example 1* - For Example 1, a printed circuit board of the present disclosure was prepared with a heat sink separating diodes of a bridge rectifier circuit and a DC-bus capacitor from a capacitor, two connectors connected to an induction coil, and a controllable solid-state switching device. Magnitude of electromagnetic interference (in dB) was then measured as a function of frequency (in kHz) of the electromagnetic emissions at a fixed power and fixed switching frequency, which were the same as used for Comparative Example 1. The measurements were then plotted on a graph, which is reproduced at FIG. 13.

As comparison of the graphs of FIGS. 12 and 13 illustrate, the heat sink of Example 1 separating the diodes of the bridge rectifier circuit and the DC-bus capacitor from the capacitor, the two connectors connected to the induction coil, and the controllable solid-state switching device causes the printed circuit board to generate much less electromagnetic interference than the set up of Comparative Example 1 without the heat sink so separating those components.

According to a first aspect of the present disclosure, a printed circuit board comprises: (a) a first edge; (b) a second edge facing an opposite direction as the first edge; (c) a first primary surface comprising a first section and a second section, the first section being disposed closer to the first edge than the second section, and the second section being disposed closer to the second edge than the first section; (d) a second primary surface facing an opposite direction as the first primary surface; (e) a heat sink projecting from the first primary surface, laterally between the first edge and the second edge, and laterally between the first section and the second section of the first primary surface; (f) one or more rectifier components configured to convert alternating current (AC) voltage to rectified direct current (DC) voltage; (g) a smoothing component projecting from the first primary surface side at the first section, the smoothing component (i) in electrical communication with the one or more rectifier components and (ii) configured to smooth out the rectified DC voltage and output a smoothed DC voltage; and (h) inverter components in electrical communication with the one or more rectifier components and the smoothing component, the inverter components comprising (i) at least one capacitor and at least one connector for an induction coil both projecting from the first primary surface of the printed circuit board at the second section and (ii) a controllable solid-state switching device functionally operable with the at least one capacitor and the at least one connector.

According to a second aspect of the present disclosure, the printed circuit board of the first aspect is presented, wherein the one or more rectifier components are arranged as a bridge rectifier circuit.

According to a third aspect of the present disclosure, the printed circuit board of any of the first through second aspects is presented wherein the one or more rectifier components project from the first primary surface at the first section.

According to a fourth aspect of the present disclosure, the printed circuit board of any one of the first through the second aspects is presented, wherein the one or more rectifier components project from the second primary surface under the first section, and closer to the first edge than the second edge.

According to a fifth aspect of the present disclosure, the printed circuit board of any one of the first through second aspects is presented, wherein the one or more rectifier components project from the second primary surface under the heat sink and in thermal communication with the heat sink by way of through-holes or a cutout through the printed circuit board.

According to a sixth aspect of the present disclosure, the printed circuit board of any one of the first through fifth aspects is presented, wherein (i) there are no rectifier components participating in the conversion of the AC voltage to the rectified DC voltage that project from the first primary surface at the second section, and (ii) there are no rectifier components participating in the conversion of the AC voltage to the rectified DC voltage that project from the second primary surface under the second section and closer to the second edge than the first edge.

According to a seventh aspect of the present disclosure, the printed circuit board of any one of the first through sixth aspects is presented, wherein the smoothing component comprises a capacitor.

According to an eighth aspect of the present disclosure, the printed circuit board of any one of the first through seventh aspects is presented, wherein there are no smoothing components that smooth the rectified DC voltage projecting from the first primary surface at the second section.

According to a ninth aspect of the present disclosure, the printed circuit board of any one of the first through eighth aspects is presented, wherein there are no capacitors or connectors for induction coils of the inverter components projecting from the second primary surface of the printed circuit board or the first primary surface of the printed circuit board at the first section.

According to a tenth aspect of the present disclosure, the printed circuit board of any one of the first through ninth aspects is presented, wherein (i) the smoothing component comprises a DC-bus capacitor, and the DC-bus capacitor is disposed proximate the first edge of the printed circuit board, and (ii) the at least one capacitor of the inverter components is disposed proximate the second edge of the printed circuit board.

According to an eleventh aspect of the present disclosure, the printed circuit board of any one of the first through tenth aspects is presented, wherein the controllable solid-state switching device is configured to convert the smoothed DC voltage into high-frequency AC voltage.

According to a twelfth aspect of the present disclosure, the printed circuit board of the eleventh aspect is presented, wherein the controllable solid-state switching device is selected from a group consisting of: a power metal-oxide-semiconductor field-effect transistor (MOSFET), an insulated-gate bipolar transistor (IGBT), a thyristor, a silicon-controlled rectifier (SCR), a silicon carbide (SiC) transistor, and a gallium nitride (GaN) transistor.

According to a thirteenth aspect of the present disclosure, the printed circuit board of any one of the first through twelfth aspects is presented, wherein the controllable solid-state switching device projects from the second primary surface of the printed circuit board, under the heat sink and in thermal communication with the heat sink by way of through-holes through the printed circuit board, or is attached to the heat sink facing toward the second section of the printed circuit board.

According to a fourteenth aspect of the present disclosure, the printed circuit board of any one of the first through thirteenth aspects are presented, wherein there are no controllable solid-state switching devices projecting from the first primary surface of the printed circuit board at the first section.

According to a fifteenth aspect of the present disclosure, the induction cooktop of any one of the first through fourteenth aspects is presented, wherein there are no controllable solid-state switching devices attached to the heat sink facing toward the first section of the printed circuit board.

According to a sixteenth aspect of the present disclosure, an induction cooktop comprises: (1) a printed circuit board comprising: (a) a first edge; (b) a second edge facing an opposite direction as the first edge; (c) a first primary surface comprising a first section and a second section, the first section being disposed closer to the first edge than the second section, and the second section being disposed closer to the second edge than the first section; (d) a second primary surface facing an opposite direction as the first primary surface; (e) a heat sink projecting from the first primary surface, laterally between the first edge and the second edge, and laterally between the first section and the second section of the first primary surface; (f) one or more rectifier components configured to convert alternating current (AC) voltage to rectified direct current (DC) voltage; (g) a smoothing component projecting from the first primary surface side at the first section, the smoothing component (i) in electrical communication with the one or more rectifier components and (ii) configured to smooth out the rectified DC voltage and output a smoothed DC voltage; and (h) inverter components in electrical communication with the one or more rectifier components and the smoothing component, the inverter components comprising (i) at least one capacitor and at least one connector for an induction coil, both projecting from the first primary surface of the printed circuit board at the second section and (ii) a controllable solid-state switching device functionally operable with the resonant capacitor and the at least one connector; (2) an induction coil connected to the connector, the induction coil paired with the at least one capacitor to form a resonant circuit; (3) a controller in electrical communication with the controllable solid-state switching device, the controller configured to drive the controllable solid-state switching device to provide an excitation signal to the resonant circuit; and (4) a substrate providing a cooking surface for cookware, and the induction coil, the printed circuit board, and the controller are disposed below the substrate.

According to a seventeenth aspect of the present disclosure, the induction cooktop of the sixteenth aspect is presented, wherein (i) the one or more rectifier components project from the first primary surface at the first section; and (ii) there are no rectifier components participating in the conversion of the AC voltage to the rectified DC voltage that project from the first primary surface at the second section.

According to an eighteenth aspect of the present disclosure, the induction cooktop of any one of the sixteenth through seventeenth aspects is presented, wherein the controllable solid-state switching device is configured to convert the smoothed DC voltage into high-frequency AC voltage.

According to a nineteenth aspect of the present disclosure, the induction cooktop of any one of the sixteenth through eighteenth aspects is presented, wherein the controllable solid-state switching device projects from the second primary surface of the printed circuit board or is attached to the heat sink facing toward the second side of the printed circuit board.

According to a twentieth aspect of the present disclosure, the induction cooktop of any one of the sixteenth through nineteenth aspects is presented, wherein the induction coil is positioned to generate a rapidly changing magnetic field that, in turn, induces eddy currents within the cookware placed upon the cooking surface.

## Claims

1. A printed circuit board (16) comprising:
a first edge (34);
a second edge (36) facing an opposite direction as the first edge (34);
a first primary surface (42) comprising a first section (48) and a second section (50), the first section (48) being disposed closer to the first edge (34) than the second section (50), and the second section (50) being disposed closer to the second edge (36) than the first section (48);
a second primary surface (44) facing an opposite direction as the first primary surface (42);
a heat sink (52) projecting from the first primary surface (42), laterally between the first edge (34) and the second edge (36), and laterally between the first section (48) and the second section (50) of the first primary surface (42);
one or more rectifier components (60) configured to convert alternating current (AC) voltage (62) to rectified direct current (DC) voltage (63);
a smoothing component (72) projecting from the first primary surface (42) at the first section (48), the smoothing component (72) (i) in electrical communication with the one or more rectifier components (60) and (ii) configured to smooth out the rectified DC voltage (63) and output a smoothed DC voltage (74); and
inverter components (78) in electrical communication with the one or more rectifier components (60) and the smoothing component (72), the inverter components (78) comprising (i) at least one capacitor (82) and at least one connector (84) for an induction coil (14) both projecting from the first primary surface (42) of the printed circuit board (16) at the second section (50) and (ii) a controllable solid-state switching device (88) functionally operable with the at least one capacitor (82) and the at least one connector (84).

2. The printed circuit board (16) of claim 1, wherein
the one or more rectifier components (60) are arranged as a bridge rectifier circuit (70).

3. The printed circuit board (16) of any one of claims 1-2, wherein
the one or more rectifier components (60) project from the first primary surface (42) at the first section (48).

4. The printed circuit board (16) of any one of claims 1-2, wherein
the one or more rectifier components (60) project from the second primary surface (44) under the first section (48), and closer to the first edge (34) than the second edge (36).

5. The printed circuit board (16) of any one of claims 1-2, wherein
the one or more rectifier components (60) project from the second primary surface (44) under the heat sink (52) and are in thermal communication with the heat sink (52) by way of through-holes (94) or a cutout through the printed circuit board (16).

6. The printed circuit board (16) of any one of claims 1-5, wherein
there are no rectifier components (60) participating in the conversion of the AC voltage to the rectified DC voltage (63) that project from the first primary surface (42) at the second section (50), and
there are no rectifier components (60) participating in the conversion of the AC voltage (62) to the rectified DC voltage (63) that project from the second primary surface (44) under the second section (50) and closer to the second edge (36) than the first edge (34).

7. The printed circuit board (16) of any one of claims 1-6, wherein
the smoothing component (72) comprises a capacitor.

8. The printed circuit board (16) of any one of claims 1-7, wherein
there are no smoothing components (72) that smooth the rectified DC voltage (63) projecting from the first primary surface (42) at the second section (50).

9. The printed circuit board (16) of any one of claims 1-8, wherein
there are no capacitors or connectors for induction coils (14) of the inverter components (78) projecting from the second primary surface (44) of the printed circuit board (16) or the first primary surface (42) of the printed circuit board (16) at the first section (48).

10. The printed circuit board (16) of any one of claims 1-9, wherein
the smoothing component (72) comprises a DC-bus capacitor (76), and the DC-bus capacitor (76) is disposed proximate the first edge (34) of the printed circuit board (16), and
the at least one capacitor of the inverter components (78) is disposed proximate the second edge (36) of the printed circuit board (16).

11. The printed circuit board (16) of any one of claims 1-10, wherein
the controllable solid-state switching device (88) is configured to convert the smoothed DC voltage (74) into high-frequency AC voltage (90).

12. The printed circuit board (16) of claim 11, wherein
the controllable solid-state switching device (88) is selected from a group consisting of: a power metal-oxide-semiconductor field-effect transistor (MOSFET), an insulated-gate bipolar transistor (IGBT), a thyristor, a silicon-controlled rectifier (SCR), a silicon carbide (SiC) transistor, and a gallium nitride (GaN) transistor.

13. The printed circuit board (16) of any one of claims 1-12, wherein
the controllable solid-state switching device (88) projects from the second primary surface (44) of the printed circuit board (16), under the heat sink (52) and in thermal communication with the heat sink (52) by way of through-holes (94) through the printed circuit board (16), or is attached to the heat sink (52) facing toward the second section (50) of the printed circuit board (16).

14. The printed circuit board (16) of any one of claims 1-13, wherein
there are no controllable solid-state switching devices (88) projecting from the first primary surface (42) of the printed circuit board (16) at the first section (48), and
there are no controllable solid-state switching devices (88) attached to the heat sink (52) facing toward the first section (48) of the printed circuit board (16).

15. An induction cooktop (10) comprising:
the printed circuit board (16) of any one of claims 1-14;
an induction coil (14) connected to the at least one connector (84), the induction coil (14) paired with the at least one capacitor (82) to form a resonant circuit;
a controller (18) in electrical communication with the controllable solid-state switching device (88), the controller (18) configured to drive the controllable solid-state switching device (88) to provide an excitation signal (96) to the resonant circuit; and
a substrate (12) providing a cooking surface (20) for cookware (22), and the induction coil (14), the printed circuit board (16), and the controller (18) are disposed below the substrate (12).
